# EUROPÄISCHE PATENTSCHRIFT

(11) **EP 2 936 542 B1**
(45) Veröffentlichungstag und Bekanntmachung des Hinweises auf die Patenterteilung: **28.02.2018**
(21) Anmeldenummer: 13830208.8
(22) Anmeldetag: 18.12.2013
(51) Int. Cl.: H01J 37/32

(54) **ARCLÖSCHVERFAHREN UND LEISTUNGSVERSORGUNGSSYSTEM MIT EINEM LEISTUNGSWANDLER**
ARC EXTINGUISHING METHOD AND POWER SUPPLY SYSTEM HAVING A POWER CONVERTER
PROCÉDÉ D'EXTINCTION D'ARC ET SYSTÈME D'ALIMENTATION EN PUISSANCE POURVU D'UN CONVERTISSEUR DE PUISSANCE

(30) Priorität: 18.12.2012 DE 102012223659; 18.12.2012 DE 102012223660
(43) Veröffentlichungstag der Anmeldung: 28.10.2015
(73) Patentinhaber: TRUMPF Hüttinger GmbH + Co. KG, 79111 Freiburg (DE)
(72) Erfinder: GREDE, André, 79110 Freiburg (DE); KRAUSSE, Daniel, 79356 Eichstetten (DE); LABANC, Anton, 79238 Ehrenkirchen (DE); THOME, Christian, 79104 Freiburg (DE); PENA VIDAL, Alberto, 79104 Freiburg (DE)
(74) Vertreter: Nitschke, Moritz
(86) Internationale Anmeldenummer: PCT/DE2013/100430
(87) Internationale Veröffentlichungsnummer: WO 2014/094738

(56) Entgegenhaltungen:
- WO-A1-2008/061784
- DE-B3-102012 223 657
- DE-U1- 9 210 382
- KR-A- 20080 048 310
- US-A- 4 700 315
- US-A1- 2006 252 283
- US-B1- 6 332 961

## Beschreibung

Die Erfindung betrifft ein Arclöschverfahren zur Löschung von Arcs in einer Plasmakammer eines Plasmasystems, umfassend die Verfahrensschritte:
a. Erzeugung einer Plasmabetriebsleistung während eines Plasmabetriebs zur Erzeugung eines Plasmas in der Plasmakammer und zur Durchführung eines Plasmabearbeitungsprozesses unter Verwendung des erzeugten Plasmas, indem mit mindestens einemDigital-Analog-Wandler ein Analogsignal generiert wird, das einem Verstärkerpfad zugeführt und dort verstärkt wird;
b. Überwachung des Plasmasystems hinsichtlich des Auftretens eines Arcs;
c. bei Erkennen eines Arcs im Schritt b.:
   Ansteuern des mindestens einen Digital-Analog-Wandlers (DAC) durch die Arcerkennung, derart, dass ein analoges Ausgangssignal des mindestens einen DACs verändert wird.

Weiterhin betrifft die Erfindung ein Leistungsversorgungssystem mit einem Leistungswandler, der zur Versorgung eines Plasmaprozesses mit Leistung mit einer Plasmakammer verbindbar ist.

Bei einem Plasma handelt es sich um einen besonderen Aggregatszustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch Zufuhr von Energie die Atome bzw. Moleküle in positive und negative Ladungsträger, also in Ionen und Elektronen, aufgespaltet werden. Ein Plasma eignet sich zur Bearbeitung von Werkstücken, da die elektrisch geladenen Teilchen chemisch hochgradig reaktiv und zudem durch elektrische Felder beeinflussbar sind. Die geladenen Teilchen können mittels eines elektrischen Feldes auf ein Objekt beschleunigt werden, wo sie beim Aufprall einzelne Atome daraus herauslösen können. Die herausgelösten Atome können über Gasfluss abtransportiert werden (Ätzen) oder auf anderen Objekten als Beschichtung abgelagert werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz, Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität. Weiterhin kann ein Plasma auch zur Anregung von Lasern, insbesondere Gaslasern, dienen.

Um aus einem Gas ein Plasma zu generieren, muss ihm Energie zugeführt werden. Das kann auf unterschiedliche Weise, beispielsweise über Licht, Wärme, elektrische Energie, erfolgen. Ein Plasma zur Bearbeitung von Werkstücken wird typischerweise in einer Plasmakammer gezündet und aufrecht erhalten. Dazu wird in der Regel ein Edelgas, z. B. Argon, mit niedrigem Druck in die Plasmakammer geleitet. Über Elektroden und/oder Antennen wird das Gas einem elektrischen Feld ausgesetzt. Ein Plasma entsteht bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirken die Entladungen bei der Kollision dieser Teilchen mit der Wand der Plasmakammer oder anderen Gegenständen sowie die natürliche Rekombination entgegen, d. h., Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Die Energiezufuhr kann über eine Gleichstrom (DC)- oder eine Wechselstrom (AC)-Leistungsversorgung erfolgen. Die bei Plasmaanregung mit einer AC-Leistungsversorgung vorkommenden Frequenzen können bis in den Gigahertzbereich hinein liegen.

Im Plasma kann es zu kurzzeitigen und auch länger anhaltenden Überschlägen, so genannten Arcs, kommen, die unerwünscht sind. Wenn ein solcher Arc erkannt wird, muss dafür gesorgt werden, dass dieser möglichst rasch erlischt, bzw. sich nicht voll entfaltet.

In KR 2008 0048310 A ist eine Plasmavorrichtung mit einer Leistungsversorgungseinheit offenbart. Eine Messvorrichtung misst ein elektrisches Signal, das an die Plasmakammer geliefert wird. Das Messergebnis wird einer Steuerungseinheit zugeführt und von dieser ausgewertet. Die Steuerungseinheit steuert die Leistungsversorgungseinheit. Die Steuerungseinheit arbeitet digital und weist einen ADC auf, der das Messergebnis digitalisiert.

In US 6 332 961 B1 ist eine Vorrichtung und ein Verfahren zur Erkennung und Vermeidung von Arcs in einem Plasmasystem offenbart, bei dem ein gemessenes Signal durch Korrelation mit Arc-Ereignissen charakterisiert wird.

In WO2008/061784 A1 ist ein Plasmabearbeitungssystem offenbart, das einen Leistungswandler, einen Überwachungsabschnitt , einen Arcableiter, einen Steuerabschnitt, einen Arcableitersteuerabschnitt, einen Arcerkennungsabschnitt und eine durch einen Benutzer steuerbare Eingabevorrichtung aufweist, die mit dem Arcableiter verbunden ist. Mit der Eingabevorrichtung können Arcerkennungsvorrichtungen, die Arcerkennungssignale außerhalb des Leistungswandler ermitteln, diese an den Arcableiter leiten.

In DE 92 10 382 U ist eine Schaltungsanordnung für ein Stromversorgungsgerät für Anlagen der Plasmatechnik offenbart mit einer Stromerfassung, die Steuerkreisen zugeführt wird. Die Steuerkreise werden von einer Mikroprozessorsteuerung und einer analogen OP-Verstärkeranordnung betätigt, wodurch eine Leistungstreiberansteuerung für Leistungsschalter gesteuert wird. Die Mikroprozessorsteuerung und die analoge OP-Verstärkeranordnung sind über je eine Schnittstelle mit einem Prozessrechner verbindbar.

In US 4 700 315 A ist ein Verfahren und eine Vorrichtung zur Steuerung eines Gasentladeprozess offenbart. Mittels eines DAC werden aus den digitalen Signalen einer Steuerung analoge Steuersignale erzeugt, die eine Stromversorgung regeln. Die Steuerung weist Vorrichtungen zur Arc-Erkennung und Arc-Unterdrückung bei Arc-Erkennung auf.

In US2006/252283 A1 ist eine Vorrichtung und ein Verfahren zur Plasmaerzeugung für Substratbearbeitung offenbart. Eine Steuerung erkennt einen Arc anhand von drei Erkennungssignalen und hält die Leistungsabgabe an das Plasma bei Arc-Erkennung kurzzeitig an.

Es ist bekannt, bei Erkennen eines Arc die Energiezufuhr vollständig abzuschalten, um so ein Erlöschen des Arcs zu erzwingen. Nachteilig bei dieser Vorgehensweise ist, dass der Plasmaprozess unterbrochen wird und es eine gewisse Zeit dauert, bis nach Erlöschen des Arcs das Plasma wieder gezündet ist und die Plasmabearbeitung fortgesetzt werden kann. Außerdem kann häufig nicht mit Sicherheit festgestellt werden, ob ein Arc erloschen ist. Es werden daher ausreichend lange Zeiten vorgesehen, in denen in der Regel ein Erlöschen eines Arcs erfolgt. Dies führt jedoch zu längeren Unterbrechungen des Plasmabearbeitungsprozesses.

Aufgabe der vorliegenden Erfindung ist es, ein Verfahren zur Löschung von Arcs in einer Plasmakammer bereit zu stellen, mit dem ein schnelleres und zuverlässigeres Löschen von Arcs erfolgen kann, ohne dabei einen Plasmabearbeitungsprozess unnötig zu beeinträchtigen. Weiterhin besteht die Aufgabe der vorliegenden Erfindung darin, ein Leistungsversorgungssystem bereit zu stellen, mit dem das erfindungsgemäße Verfahren durchgeführt werden kann.

Gelöst wird diese Aufgabe erfindungsgemäß durch ein Arclöschverfahren nach Anspruch 1.

Ein solches Arclöschverfahren ist um ein Vielfaches schneller als herkömmliche Arclöschverfahren. Es ist auch viel flexibler einstellbar. Das Arclöschverfahren bewirkt einen effektiven Schutz eines Leistungswandlers bei auftretenden Überschlägen (Arcs) in einer Plasmakammer. Außerdem kann ein schnelles Wiedereinschalten der Leistung nach dem Erkennen von Arcs zur Reduzierung der Auswirkungen auf das Substrat im Plasmaprozess erfolgen.

Bisher war es üblich, bei Überschlägen in einer Plasmaanwendung die zugeführte Leistung bei Erkennen eines Arcs sofort auszutasten. Dies hatte zum Ziel, einerseits den Überschlag in der Kammer zu löschen und die damit in der Kammer befindlichen Substrate zu schützen und andererseits die aktiven Bauteile in dem Leistungswandler zu schützen. Durch die Verwendung von robusten Halbleitern und eine entsprechend schnelle Steuerung kann die Leistung erfindungsgemäß nur soweit reduziert werden, dass der Überschlag vollständig erlischt. Die Plasmabetriebsleistung kann auf die Arclöschleistung nur solange reduziert werden, bis der Überschlag vollständig erloschen ist. Anschließend kann die Leistung sofort wieder auf 100% gefahren werden, d.h. die volle Plasmabetriebsleistung an die Plasmakammer geliefert werden. Dies hat den Vorteil, dass die vollständige Plasmazündung innerhalb der Kammer schneller wieder hergestellt wird im Vergleich zu Verfahren des Standes der Technik. Somit werden die Auswirkungen des Überschlags und somit des Austastens der Leistung deutlich reduziert.

Ein oder mehrere weitere DAC können in Abhängigkeit von der Überwachung des Plasmasystems hinsichtlich des Auftretens eines Arcs angesteuert werden und das jeweilige analoge Ausgangssignal der DAC kann in einem nachfolgenden Verstärkerpfad zu einem Teil der Plasmaleistung oder der Arclöschleistung verstärkt werden. Somit können mehrere Verstärkerpfade parallel betrieben werden. Dies bedeutet, dass in einem einzelnen Verstärkerpfad keine zu große Leistung erzeugt werden muss, was sich günstig auf die Kosten für die in einem Verstärkerpfad verwendeten Bauteile auswirkt.

Gelöst wird diese Aufgabe erfindungsgemäß außerdem durch ein Arclöschverfahren zur Löschung von Arcs in einer Plasmakammer eines Plasmasystems, umfassend die Verfahrensschritte:
a. Erzeugung einer Leistung während eines Plasmabetriebs zur Erzeugung eines Plasmas in der Plasmakammer und zur Durchführung eines Plasmabearbeitungsprozesses unter Verwendung des erzeugten Plasmas, indem mit mindestens einem Digital- Analog-Wandler (DAC) ein Analogsignal generiert wird, das einem Verstärkerpfad zugeführt und dort verstärkt wird;
b. Überwachung des Plasmasystems hinsichtlich des Auftretens eines Arcs durch eine Arcerkennung;
c. bei Erkennung eines Arcs im Schritt b:
   Ansteuern des mindestens einen Digital-Analog-Wandlers (DAC) durch die Arcerkennung, derart, dass ein analoges Ausgangssignal des mindestens einen Digital-Analog-Wandlers verändert wird wobei die Erzeugung der Leistung erfolgt, indem eine Hochfrequenzleistung erzeugt wird und der oder die Digital-Analog-Wandler (DAC) so angesteuert werden (wird), dass diese(r) ein Signal mit dieser Frequenz erzeugen (erzeugt).

Insbesondere kann durch die Arcerkennung ein Arcerkennungssignal erzeugt werden, durch welches der Digital-Analog-Wandler (DAC) direkt angesteuert wird. Somit wird keine Zeit dadurch verloren, dass das Arcerkennungssignal beispielsweise über eine Logikschaltung geleitet wird, in der es verarbeitet wird. Das Arcerkennungssignal wird somit vorzugsweise dem DAC unmittelbar, ohne zwischengeschaltete Logik, zugeführt. Dadurch ist eine sehr schnelle Reaktion, z.B. Abschaltung, bei erkannten Überschlägen möglich, indem das dem Verstärkerpfad zugeführte Analogsignal verändert wird. Das Plasmaversorgungssystem wird dadurch geschützt. Die Verwendung einer zeitintensiven Logik zwischen Messaufnehmern und einer Leistungssteuerung, was zu einer langen Reaktionszeit und somit zu einer langsamen Reaktion auf einen Arc führen würde, kann vermieden werden.

Ein solches Arclöschverfahren ist um ein Vielfaches schneller als herkömmliche Arclöschverfahren. Das Arclöschverfahren bewirkt einen effektiven Schutz eines Leistungswandlers bei auftretenden Überschlägen (Arcs) in einer Plasmakammer.

Ein oder mehrere weitere DAC können bei Erkennen eines Arcs durch die Arcerkennung angesteuert werden. Als Reaktion auf das Erkennen eines Arcs kann beispielsweise die Leistung nur so weit reduziert werden, dass der Überschlag vollständig erlischt. Ist der Arc erloschen, kann die Leistung relativ schnell wieder hergestellt werden. Wenn mehrere DAC vorgesehen sind, können auch mehrere Verstärkerpfade vorgesehen sein, die parallel betrieben werden. Dies bedeutet, dass in einem einzelnen Verstärkerpfad keine zu große Leistung erzeugt werden muss, was sich günstig auf die Kosten für die in einem Verstärkerpfad verwendeten Bauteile auswirkt. Weiterhin kann durch Ansteuerung mehrerer DAC, die mehreren Verstärkerpfaden zugeordnet sind, schnell auf das Auftreten eines Arcs reagiert werden.

Die analogen Ausgangssignale von zumindest zwei DAC in den jeweils nachfolgenden Verstärkerpfaden können unterschiedlich verstärkt werden oder unterschiedliche Durchlaufzeiten durch die Verstärkerpfade erfahren. Somit kann durch Verwendung unterschiedlicher Verstärkerpfade eine Gesamtleistung eingestellt werden, die sich aus der Kopplung oder Kombination der Ausgangsleistungen der einzelnen Verstärkerpfade ergibt. Dadurch lässt sich die der Plasmakammer zugeführte Leistung sehr viel flexibler einstellen als bei Verwendung nur eines Verstärkerpfads oder bei Verwendung von Verstärkerpfaden die exakt die gleiche Ausgangsleistung generieren.

Ein Referenzsignaleingang des DAC kann durch die Arcerkennung angesteuert werden. Insbesondere kann eine Eingangsspannung oder ein Eingangsstrom an dem Referenzsignaleingang verändert werden. Das Referenzsignal kann dazu verwendet werden, das Ausgangssignal des DAC zu beeinflussen. Dadurch ist insbesondere eine sehr schnelle Beeinflussung des Ausgangssignals des DAC und somit eine sehr schnelle Veränderung der der Plasmakammer zugeführten Leistung möglich. Insbesondere kann die in die Plasmakammer gelieferte Leitung reduziert werden, um einen Arc zum Erlöschen zu bringen.

Das analoge Ausgangssignal eines DAC kann insbesondere dann besonders schnell und zuverlässig eingestellt werden, wenn dem DAC eine Folge von Digitalwerten zugeführt wird. Dabei können die Digitalwerte in einem Speicher, insbesondere einer Nachschautabelle (Look-Up-Table), abgelegt sein.

In zumindest einem Verstärkerpfad kann das analoge Ausgangssignal des zugeordneten DAC mit einem konstanten Verstärkungsfaktor verstärkt werden. Dadurch können die im Verstärkerpfad verwendeten Verstärker besonders einfach gehalten werden.

Zumindest einem DAC kann dieselbe Folge von Digitalwerten zugeführt werden, unabhängig davon, ob ein Arc erkannt wurde oder nicht. Die Reaktion auf das Erkennen eines Arcs erfolgt somit nicht durch die zugeführte Folge von Digitalwerten, sondern kann auf andere Art und Weise bewirkt werden, die unter Umständen schneller ist als die Veränderung des analogen Ausgangssignals des DAC aufgrund einer veränderten Folge von Digitalwerten.

Zumindest einem DAC kann bei Arcerkennung ein anderes Referenzsignal zugeführt werden als bei fehlender Arcerkennung. Das Referenzsignal kann dazu verwendet werden, das Ausgangssignal des DAC zu beeinflussen. Die Ansteuerung des DAC mit dem Referenzsignal kann zu einer deutlich schnelleren Änderung des Ausgangssignals des DAC führen als die Veränderung der zugeführten Folge von Digitalwerten.

Wenn zumindest einem DAC im Plasmabetrieb dasselbe Referenzsignal zugeführt wird wie im Arclöschbetrieb, kann die Veränderung des analogen Ausgangssignals des DAC dadurch erfolgen, dass eine veränderte Folge von Digitalwerten zugeführt wird.

Es kann überwacht werden, ob der detektierte Arc erloschen ist und bei Detektion des Erlöschens des Arcs kann kein Arcerkennungssignal dem DAC zugeführt werden. Es wird somit keine vorbestimmte Zeit abgewartet, bis die Leistung der Plasmakammer wieder zugeführt wird. Eine solche vordefinierte Zeit ist unter Umständen länger als die Zeit, die tatsächlich zum Erlöschen des Arcs benötigt wird. Wird dagegen überwacht, ob der Arc erloschen ist, kann unmittelbar nach Erlöschen des Arcs die Leistung der Plasmakammer wieder zugeführt werden. Somit kann die Unterbrechungszeit des Plasmaprozesses minimal gehalten werden.

Zumindest ein analoges Ausgangssignal eines DAC kann durch einen Direct Digital Synthesis-Baustein (DDS-Baustein) erzeugt werden, der den DAC aufweist. Mit einem DDS-Baustein kann eine besonders schnelle Erzeugung eines analogen Ausgangssignals bewirkt werden. Die Arclöschung und somit die Minimierung der Leistung, die der Plasmakammer zugeführt wird, kann dadurch bewirkt werden, dass ein Referenzsignaleingang des DDS-Bausteins angesteuert wird, insbesondere eine Eingangsspannung an dem Referenzsignaleingang verändert, insbesondere erhöht wird. Durch eine solche Ansteuerung des DDS-Bausteins kann das analoge Ausgangssignal und somit die der Plasmakammer zugeführte Leistung besonders schnell verändert werden.

Jedem DAC kann eine eigene (individuelle) Folge von Digitalwerten zugeführt werden. Somit kann das erzeugte Ausgangssignal des DAC individuell eingestellt werden. Insbesondere können unterschiedlichen Verstärkerpfaden unterschiedliche analoge Eingangssignale zugeführt werden. Dadurch lässt sich die Gesamtleistung, die einer Plasmakammer zugeführt wird, besonders flexibel einstellen.

Die Folge von Digitalwerten kann aus einem Datenspeicher ausgelesen werden, der von einer zentralen Logikbaugruppe beschrieben wird. Bei den Datenspeichern kann es sich um sogenannte Nachschautabelle (Look-Up-Tabels) handeln.

Die Folge von Digitalwerten kann erzeugt werden, indem ein in einem Signaldatenspeicher abgelegter Signaldatenwert mit einem in einem Amplitudendatenspeicher abgelegten Amplitudendatenwert multipliziert wird. Insbesondere kann die Folge von Digitalwerten erzeugt werden, indem mit Hilfe eines Zählers eine Folge von in einem Signaldatenspeicher abgelegten Signaldatenwerten ausgelesen wird, diese Folge von Signaldatenwerten einem Multiplizierer zugeführt wird, und von diesem Multiplizierer mit einem aus einem Amplitudendatenspeicher ausgelesenen Amplitudendatenwert multipliziert wird. Dabei kann ein Analogsignal eine Analogspannung sein. Somit kann auf einfache Art und Weise ein Digitalsignal erzeugt werden, welches Informationen bezüglich der Signalform und der Amplitude des im DAC zu erzeugenden Analogsignals aufweist. Dies hat insbesondere dann Vorteile, wenn parallel mehrere Analogsignale erzeugt werden, die anschließend durch einen Kombinierer kombiniert werden, so dass die zu kombinierenden Signale besonders einfach und schnell aneinander angepasst werden können. Verstärkerpfade, die mit einem so generierten Analogsignal angesteuert sind, sind besonders gut für einen Parallelbetrieb mehrerer Verstärkerpfade geeignet. Die so erzeugten Leistungen können einfach am Ausgang der Verstärkerpfade kombiniert werden. Somit ergibt sich eine sehr schnell und genau abstimmbare Gesamtleistung eines Leistungswandlers.

Die Arcerkennung kann eine Arc-Managementschaltung ansteuern, die wiederum direkt oder indirekt den oder die DAC ansteuert. Durch das von der Arcerkennung generierte Arcerkennungssignal kann zunächst der DAC angesteuert werden, um sehr schnell auf den erkannten Arc zu reagieren. Durch die Arc-Managementschaltung kann diese schnelle Arcerkennung ergänzt werden, indem weitere Entscheidungen zur Behandlung des Arcs getroffen werden.

Die Arc-Managementschaltung kann die Amplitude des Analogsignals beeinflussen, indem der im Amplituden-Datenspeicher abgelegte Amplituden-Datenwert verändert wird. So kann die Amplitudenmodulation besonders schnell erfolgen. Außerdem können mehrere Verstärkerpfade so sehr schnell in ihrer Ausgangsleistung verändert werden und gleichzeitig bleibt die Synchronisierung der Verstärkerpfade untereinander unberührt.

Die Arc-Managementschaltung kann die Amplitude des Analogsignals beeinflussen, indem der im Signal-Datenspeicher abgelegte Signal-Datenwert verändert wird. Auch so kann die Amplitudenmodulation besonders schnell erfolgen. Außerdem können mehrere Verstärkerpfade so sehr schnell in ihrer Ausgangsleistung verändert werden und eine nichtlineare Verstärkung und Phasenschiebung bei unterschiedlichen Amplituden des Analogsignals der Verstärker kann mit berücksichtigt werden.

Die Überwachung des Plasmasystems kann hinsichtlich des Auftretens eines Arcs erfolgen, indem ein mit der in das Plasma gelieferten Leistung Pi und/oder ein mit der von dem Plasma reflektierten Leistung Pr und/oder mit einem in das Plasma fließenden Strom und/oder einer an das Plasma angelegten Spannung in Beziehung stehendes Signal erfasst wird und aus dem erfassten Signal mittels der Arcerkennung ein Arcerkennungssignal generiert wird. Insbesondere kann das erfasste Signal von einem Analog-Digital-Wandler (ADC) in digitalisierte Werte umgesetzt werden, diese digitalisierten Werte können einer Logikschaltung, insbesondere einem programmierbaren Logikbaustein, zugeführt werden, wobei der programmierbare Logikbaustein diese digitalisierten Werte auswertet und das Arcerkennungssignal generiert. Mit einer solchen optimierten und spezialisierten Logik kann die Geschwindigkeit der Arcerkennung erheblich gesteigert werden. Weiterhin genügt in diesem Fall ein einziges Signal, um über die Existenz eines Arcs zu informieren und das Plasmasystem z.B. abzuschalten. Durch die direkte Anbindung des Arcerkennungssignals an den DAC kann der Arc praktisch ohne Verzögerung wahrgenommen werden. Dadurch ist quasi eine Echtzeitüberwachung von Signalen des Plasmasystems und eine sehr schnelle Abschaltung des Systems bei Überschlägen möglich. Die Verwendung einer zeitintensiven Logik zwischen Messaufnehmern und einer Systemsteuerung führt zu einer langen Reaktionszeit und damit zu einer langsamen Reaktion, was erfindungsgemäß vermieden wird. Durch Verwendung einer spezifischen Leitung zur Übertragung des Arcerkennungssignals kann eine minimale Verzögerung realisiert werden.

Die Erzeugung der Leistung kann erfolgen, indem eine Hochfrequenzleistung, insbesondere mit einer Frequenz > 1 MHz erzeugt wird und der oder die DAC so angesteuert werden, dass diese(r) ein Signal mit dieser Frequenz erzeugen.

Das erfasste Signal kann von dem ADC mit einer Frequenz > 1 MHz abgetastet werden und der programmierbare Logikbaustein kann mit einem Taktsignal einer Frequenz > 1 MHz getaktet werden. Dem ADC und dem programmierbaren Logikbausein kann dasselbe Taktsignal zugeführt werden. Dadurch wird eine schnellstmögliche Signalverarbeitung sichergestellt.

Dem zumindest einen Verstärkerpfad kann ein von einem DAC aus einem Digitalsignal erzeugtes Analogsignal zugeführt werden. Das Analogsignal kann in dem Verstärkerpfad zu einem Hochfrequenzleistungssignal verstärkt werden. Das Digitalsignal kann insbesondere erzeugt werden, indem ein in einem Signal-Datenspeicher abgelegter Signal-Datenwert mit einem in einem Amplituden-Datenspeicher abgelegten Amplituden-Datenwert multipliziert werden. So kann sehr schnell auf eine Arcerkennung reagiert werden.

Insbesondere kann die Folge von Digitalwerten erzeugt werden, indem mit Hilfe eines Zählers eine Folge von in einem Signaldatenspeicher abgelegten Signaldatenwerten ausgelesen wird, diese Folge von Signaldatenwerten einem Multiplizierer zugeführt wird, und von diesem Multiplizierer mit einem aus einem Amplitudendatenspeicher ausgelesenen Amplitudendatenwert multipliziert wird.

Den zumindest zwei Verstärkerpfaden kann jeweils ein von einem DAC aus jeweils einem Digitalsignal erzeugtes Analogsignal zugeführt werden. Die Analogsignale können in jeweils einem Verstärkerpfad zu einem Hochfrequenzleistungssignal verstärkt werden. Die Digitalsignale können erzeugt werden, indem ein in einem Signal-Datenspeicher abgelegter Signal-Datenwert mit einem in einem Amplituden-Datenspeicher abgelegten Amplituden-Datenwert multipliziert wird. So kann besonders schnell und flexibel auf eine Arcerkennung reagiert werden.

Zum Umschalten von der Erzeugung der Plasmabetriebsleistung zur Erzeugung der Arclöschleistung können die im Amplituden-Datenspeicher abgelegten Amplituden-Datenwerte geändert werden. Damit können die Verstärkerpfade sehr schnell in ihrer Ausgangsleistung verändert werden und gleichzeitig bleibt die Synchronisierung der Verstärkerpfade untereinander unberührt.

Die Multiplikation der in den Amplituden-Datenspeichern abgelegten Amplituden-Datenwerte mit den in den Signal-Datenspeichern abgelegten Signal-Datenwerten kann in einem DDS-Baustein durchgeführt werden. Das reduziert die Anzahl der Bauteile und die Kosten.

Die Arclöschleistung kann so gewählt werden, dass der detektierte Arc erlischt. Während es bisher üblich war, bei Erkennen eines Überschlags die Leistung auszutasten und anschließend wieder einzuschalten, in der Annahme, dass der Überschlag erloschen ist, ist es erfindungsgemäß möglich, die Leistung, die in die Plasmakammer geliefert wird, von der Plasmabetriebsleistung auf die Arclöschleistung zu reduzieren. Durch das kontinuierliche Liefern einer Arclöschleistung an die Kammer kann jedoch auch erkannt und sicher gestellt werden, ob und dass der Überschlag auch tatsächlich erloschen ist. Sobald erkannt wird, dass der Arc tatsächlich erloschen ist, kann die Arclöschleistung wieder auf die Plasmabetriebsleistung erhöht werden. Insbesondere bei Prozessen, die bereits bei niedriger Prozessenergie zünden, kann durch die Reduktion der Leistung der Plasmaprozess zunächst auf einem niedrigen Energielevel (z.B. geringere Beschichtungsrate) weiter betrieben werden. Nach sicherem Erkennen des Erlöschens des Arcs kann der Prozess wieder mit den ursprünglichen Parametern weiter betrieben werden. Dies reduziert die von der Plasmakammer und einem Anpassungsnetzwerk an den Leistungswandler reflektierte Energie und erhöht somit die Lebensdauer des Leistungswandlers.

In zumindest einem Verstärkerpfad kann das analoge Ausgangssignal des zugeordneten DAC sowohl im Plasmabetrieb als auch im Arclöschbetrieb mit einem konstanten Verstärkungsfaktor verstärkt werden. Dadurch können die im Verstärkerpfad verwendeten Verstärker besonders einfach gehalten werden. Weiterhin kann vorgesehen sein, dass im Plasmabetrieb und im Arclöschbetrieb derselbe Verstärkungsfaktor verwendet wird.

Zumindest einem DAC kann im Plasmabetrieb und im Arclöschbetrieb dieselbe Folge von Digitalwerten zugeführt werden. Die Änderung von der Plasmabetriebsleistung auf die Arclöschleistung erfolgt somit nicht durch die zugeführte Folge von Digitalwerten sondern kann auf andere Art und Weise bewirkt werden, die unter Umständen schneller ist als die Veränderung des analogen Ausgangssignals des DAC aufgrund einer veränderten Folge von Digitalwerten.

Durch zumindest einen DAC kann im Plasmabetrieb ein anderes analoges Ausgangssignal erzeugt werden als im Arclöschbetrieb. Dadurch lässt sich auf besonders einfache Art und Weise im Arclöschbetrieb eine Arclöschleistung einstellen.

Zumindest einem DAC kann im Plasmabetrieb ein anderes Referenzsignal zugeführt werden als im Arclöschbetrieb. Das Referenzsignal kann dazu verwendet werden, das Ausgangssignal des DAC zu beeinflussen. Die Ansteuerung des DAC mit dem Referenzsignal kann zu einer deutlich schnelleren Änderung des Ausgangssignals des DAC führen als die Veränderung der zugeführten Folge von Digitalwerten.

Wenn zumindest einem DAC im Plasmabetrieb dasselbe Referenzsignal zugeführt wird wie im Arclöschbetrieb, kann die Veränderung des analogen Ausgangssignals des DAC dadurch erfolgen, dass eine veränderte Folge von Digitalwerten zugeführt wird.

Weiterhin kann vorgesehen sein, dass allen DAC im Plasmabetrieb dasselbe Plasmabetriebsreferenzsignal zugeführt wird. Weiterhin kann allen DAC im Arclöschbetrieb dasselbe Arclöschbetriebsreferenzsignal zugeführt werden. Die Änderung von einer Plasmabetriebsleistung zu einer Arclöschleistung kann daher besonders einfach dadurch erfolgen, dass den DAC ein anderes Referenzsignal zugeführt wird.

Es kann überwacht werden, ob der detektierte Arc erloschen ist und bei Detektion des Erlöschens des Arcs kann die Plasmabetriebsleistung wieder erzeugt und der Plasmakammer zugeführt werden. Es wird somit keine vorbestimmte Zeit abgewartet, bis die Plasmabetriebsleistung der Plasmakammer wieder zugeführt wird. Eine solche vordefinierte Zeit ist unter Umständen länger als die Zeit, die tatsächlich zum Erlöschen des Arcs benötigt wird. Wenn dagegen überwacht wird, ob der Arc erloschen ist, kann unmittelbar nach Löschen des Arcs die Plasmabetriebsleistung der Plasmakammer wieder zugeführt werden. Somit kann die Unterbrechungszeit des Plasmaprozesses minimal gehalten werden.

Bei Erkennen eines Arcs kann stufenweise oder rampenförmig von der Plasmabetriebsleistung auf die Arclöschleistung übergegangen werden. Zu große Leistungssprünge in der Plasmakammer können dadurch vermieden werden.

Insbesondere kann nach dem Erkennen eines Arcs überwacht werden, ob der detektierte Arc erloschen ist und bis zur Detektion des Erlöschens des Arcs der Arclöschleistung stufenweise oder rampenförmig verringert werden. Somit kann die Arclöschleistung immer weiter aber auch nur dann reduziert werden, wenn der Arc noch nicht erloschen ist. Es wird auf diese Art und Weise verhindert, dass die Arclöschleistung zu weit abgesenkt wird.

Bei Erkennen eines Arcs kann von der Plasmabetriebsleistung auf eine Arclöschleistung übergegangen werden, die > 0 Watt ist. Somit wird die Leistungszufuhr nicht komplett ausgetastet sondern stets eine gewisse Leistung der Plasmakammer zugeführt, auch im Arclöschbetrieb.

Die Anzahl oder Höhe der Stufen des stufenförmigen Übergangs oder die Steilheit des rampenförmigen Übergangs können einstellbar sein. Somit kann der Übergang von der Plasmabetriebsleistung auf die Arclöschleistung in Abhängigkeit von dem durchgeführten Plasmaprozess gewählt werden.

Zumindest ein analoges Ausgangssignal eines DAC kann durch einen Direct Digital Synthesis-Baustein (DDS-Baustein) erzeugt werden, der den DAC aufweist. Mit einem DDS-Baustein kann eine besonders schnelle Erzeugung eines analogen Ausgangssignals bewirkt werden. Der Übergang von der Plasmabetriebsleistung zu der Arclöschleistung kann dadurch bewirkt werden, dass ein Referenzsignaleingang des DDS-Bausteins angesteuert wird, insbesondere eine Eingangsspannung an dem Referenzsignaleingang erhöht wird. Durch eine solche Ansteuerung des DDS-Bausteins kann das analoge Ausgangssignal und somit die der Plasmakammer zugeführte Leistung besonders schnell verändert werden.

Jedem DAC kann eine eigene (individuelle) Folge von Digitalwerten zugeführt werden. Somit kann das erzeugte Ausgangssignal des DAC individuell eingestellt werden. Insbesondere können unterschiedlichen Verstärkerpfaden unterschiedliche analoge Eingangssignale zugeführt werden. Dadurch lässt sich die Gesamtleistung, die einer Plasmakammer zugeführt wird, besonders flexibel einstellen.

Die Folge von Digitalwerten kann aus einem Datenspeicher ausgelesen werden, der von einer zentralen Logikbaugruppe beschrieben wird. Bei den Datenspeichern kann es sich um sogenannte Look-Up-Tables handeln.

In den Rahmen der Erfindung fällt außerdem ein Leistungsversorgungssystem mit einem ein Hochfrequenzsignal erzeugenden Leistungswandler, der zur Versorgung eines Plasmaprozesses mit Hochfrequenz-Leistung mit einer Plasmakammer verbindbar ist, wobei der Leistungswandler einen ersten Verstärkerpfad aufweist, dadurch gekennzeichnet, dass das Leistungsversorgungssystem weiter einen Digital-Analog-Wandler (DAC) aufweist, der dem Verstärkerpfad vorgeschaltet ist, und dass dem ersten Verstärkerpfad ein von dem DAC erzeugtes Analogsignal zugeführt ist, wobei der DAC zumindest mittelbar mit einer Arcerkennung verbunden ist. Dies bedeutet, dass die Arcerkennung unmittelbar ein Signal an einen DAC geben kann. Alternativ ist es denkbar, dass eine Arcerkennung über einen weiteren Baustein, beispielsweise einen Steuerbaustein mit dem DAC verbunden ist. Eine besonders schnelle Reaktion auf das Erkennen eines Arcs kann jedoch dadurch bewirkt werden, dass die Arcerkennung unmittelbar mit dem DAC verbunden ist und somit unmittelbar das vom DAC erzeugte Ausgangssignal beeinflusst.

Der DAC kann einen Digitalsignaleingang und einen Referenzsignaleingang aufweisen. Ferner kann eine Ansteuerschaltung vorgesehen sein, die in Abhängigkeit von einem durch die Arcerkennung ermittelten Arcerkennungssignals zumindest ein Eingangssignal für einen Eingang eines DAC erzeugt. Insbesondere kann die Arcerkennung das Referenzsignal, welches dem Referenzsignaleingang zugeführt wird, verändern. Selbst bei gleichbleibender Folge von Digitalwerten, die dem DAC zugeführt werden, kann somit das von dem DAC erzeugte Ausgangssignal beeinflusst werden. Dadurch kann besonders schnell eine Reduktion von der Plasmabetriebsleistung auf die Arclöschleistung erfolgen.

Der Leistungswandler kann mehrere Verstärkerpfade aufweisen, denen jeweils ein DAC zugeordnet ist, der den jeweiligen Verstärkerpfad an ein Analogsignal zuführt. Somit kann parallel in mehreren Verstärkerpfaden ein Leistungssignal erzeugt werden. In den Verstärkerpfaden kann dasselbe Leistungssignal erzeugt werden oder es können unterschiedliche Leistungssignale erzeugt werden.

Dem zumindest einen Verstärkerpfad kann ein von einem DAC aus einem Digitalsignal erzeugtes Analogsignal zugeführt werden. Dabei kann dem DAC insbesondere eine Logikschaltungseinheit zur Erzeugung des dem DAC zugeführten Digitalsignals vorgeschaltet sein. Die Logikschaltungseinheit kann dabei insbesondere eine oder mehrere der folgenden Einheiten aufweisen:
- einen Signal-Datenspeicher, in dem Signal-Datenwerte zur Erzeugung einer Analogsignalform abgelegt sind,
- einen Amplituden-Datenspeicher, in dem Amplituden-Datenwerte zur Beeinflussung der Amplituden der Analogsignale abgelegt sind, und
- einen Multiplikator zur Multiplikation der Signal-Datenwerte mit den Amplituden-Datenwerten.

Auf diese Weise kann sehr schnell auf eine Arcerkennung reagiert werden.

Den zumindest zwei Verstärkerpfaden können jeweils ein von jeweils einem DAC aus einem Digitalsignal erzeugtes Analogsignal zugeführt sein. Dabei können insbesondere jedem DAC eine Logikschaltungseinheit zur Erzeugung der dem DAC zugeführten Digitalsignale vorgeschaltet sein. Dabei kann die Logikschaltungseinheit insbesondere eine oder mehrere der folgenden Einheiten aufweisen:
- einen Signal-Datenspeicher, in dem Signal-Datenwerte zur Erzeugung einer Analogsignalform abgelegt sind,
- einen Amplituden-Datenspeicher, in dem Amplituden-Datenwerte zur Beeinflussung der Amplituden der Analogsignale abgelegt sind, und
- einen Multiplikator zur Multiplikation der Signal-Datenwerte mit den Amplituden-Datenwerten.
Auf diese Weise kann sehr schnell auf eine Arcerkennung reagiert werden und die einzelnen Verstärkerpfade arbeiten trotzdem weiter synchron. Die Einheiten können in einem DDS integriert sein.

Die Arcerkennung kann derart mit der Logikschaltungseinheit verbunden sein, dass sie den Amplituden-Datenspeicher beeinflussen kann. Auf diese Weise kann besonders schnell auf eine Arcerkennung reagiert werden und die einzelnen Verstärkerpfade arbeiten trotzdem weiter synchron.

Die Einheiten können in einem DDS-Baustein integriert sein. Das reduziert die Anzahl der Bauteile und die Kosten.

Die Verstärkerpfade können mit einem Koppler oder Kombinierer zur Kopplung der in den Verstärkerpfaden erzeugten Leistungen zu einer Gesamtleistung verbunden sein. Somit kann parallel in mehreren Verstärkerpfaden jeweils eine relativ geringe Leistung erzeugt werden, die anschließend über einen Kombinierer gekoppelt werden. Die am Kombinierer ausgegebene Gesamtleistung kann somit besonders flexibel und kostengünstig erzeugt werden.

Der Kombinierer kann zur Kopplung der in den Verstärkerpfaden erzeugten Leistungen ohne Ausgleichsimpedanzen für Eingangssignale ungleicher Stärke und/oder Phasenlage ausgelegt sein. Dadurch ergibt sich ein besonders einfacher und kostengünstiger Aufbau des Kombinierers.

Die Verstärkerpfade können Transistoren in LDMOS-Technologie aufweisen. LDMOS-Transistoren zeichnen sich durch eine extrem hohe Strombelastbarkeit aus. Sie haben allerdings den Nachteil, dass sie nur bei relativ geringen Spannungen betrieben werden können, was für Leistungen, wie sie bei der industriellen Plasmaerzeugung benötigt werden, nicht ausreichen würde. Der Vorteil eines Leistungswandlers mit mehreren Verstärkerpfaden und einem einfachen Kombinierer besteht darin, dass in jedem Pfad nur eine geringe Spannung mit hohem Strom am verstärkenden Transistor (insbesondere LDMOS-Transistor) anliegen kann, also ein Signal mit geringer Impedanz erzeugt werden kann. Mehrere solcher Signale können durch den Kombinierer zu der für den Plasmaprozess benötigten Gesamtleistung gekoppelt werden.

Die Ansteuerschaltung kann als FPGA ausgebildet sein, das mit einem DAC der Verstärkerpfade verbunden ist oder in ein solches integriert sein. Eine als FPGA ausgebildete Ansteuerschaltung kann besonders schnell arbeiten.

Das FPGA kann durch einen digitalen Signalprozessor (DSP) angesteuert sein. Auch dadurch ergibt sich eine besonders schnelle Signalverarbeitung und entsprechend schnelle Reaktion auf das Erkennen eines Arcs in der Plasmakammer.

In den Rahmen der Erfindung fällt außerdem ein Leistungsversorgungssystem mit einem Leistungswandler, der zur Versorgung eines Plasmaprozesses mit Leistung mit einer Plasmakammer verbindbar ist, wobei der Leistungswandler einen ersten Verstärkerpfad aufweist, dem ein von einem DAC erzeugtes Analogsignal zugeführt ist, wobei der DAC mit einer Arcerkennung verbunden ist. Insbesondere kann der DAC unmittelbar, d.h. direkt ohne zwischengeschaltete Logik, mit der Arcerkennung verbunden sein. Dies bedeutet, dass die Arcerkennung unmittelbar ein Signal an einen DAC geben kann. Eine besonders schnelle Reaktion auf das Erkennen eines Arcs kann dadurch bewirkt werden. Somit kann unmittelbar das vom DAC erzeugte Ausgangssignal beeinflusst werden.

Eine Signalleitung kann von der Arcerkennung zu dem DAC durch eine Logikbaugruppe geschleift sein. Die Logikbaugruppe kann dazu dienen, den DAC im arcfreien Betrieb anzusteuern. Das "Verlegen" einer extra Leitung kann vermieden werden, wenn die Signalleitung durch die Logikbaugruppe geschleift wird. Eine Übertragung des Arcerkennungssignals über eine Signalleitung, die durch eine Logikbaugruppe geschleift ist, wird im Sinne der Erfindung dennoch als unmittelbare Verbindung der Arcerkennung mit dem DAC verstanden, da das Arcerkennungssignal in der Logikbaugruppe keine weitere Verarbeitung und Auswertung erfährt.

Es kann eine Messeinrichtung vorgesehen sein, in die die Arcerkennung integriert ist. Die Messeinrichtung kann dazu ausgelegt sein, Strom, Spannung und/oder Leistung, insbesondere Vorwärts- und Rückwärtsleistung, d.h. reflektierte Leistung zu erfassen. Insbesondere kann die Messeinrichtung mit eingebetteter Digitalisierung und Aufbereitung der gemessenen Signale ausgestattet sein. Durch zusätzliche Logikbauelemente kann die Erzeugung des Arcerkennungssignals direkt dort erfolgen.

Die Messeinrichtung kann einen Richtkoppler aufweisen. Ein Richtkoppler kann ausgelegt sein zur Erfassung von Leistung, insbesondere von Vorwärts- und Rückwärtsleistung.

Die Messeinrichtung kann einen Stromwandler aufweisen. Der Stromwandler kann beispielsweise als Rogowsky-Spule ausgebildet sein. Die Rogowsky-Spule kann in Flachbauweise ausgeführt sein.

Die Messeinrichtung kann einen ADC aufweisen. Insbesondere können die Messeinrichtung und der ADC auf einer Leiterkarte angeordnet sein. Die Messeinrichtung kann in planarer Bauweise ausgeführt sein. Insbesondere kann ein Filter zwischen dem ADC und der Messeinrichtung angeordnet sein. Auch der Filter kann auf derselben Leiterkarte angeordnet sein wie der ADC und die Messeinrichtung.

Die Messeinrichtung kann eine Logikschaltung zur Generierung des Arcerkennungssignals aufweisen. Die Logikschaltung kann dabei eine programmierbare Logikschaltung (PLD) sein. Dies hat den Vorteil, dass die Logikschaltung durch einen Anwender veränderbar, insbesondere programmierbar ist. Die programmierbare Logikschaltung kann dabei beispielsweise als sogenanntes FPGA (Field Programmable Gate Array) ausgebildet sein. Diese Logikbaugruppe kann auf derselben Leiterkarte angeordnet sein wie die Messeinrichtung und der ADC. Insbesondere können ADC und Logikschaltung in einem Baustein realisiert sein. Die Takterzeugung kann ebenfalls auf dieser Leiterkarte erfolgen. Alternativ kann ein Takt extern erzeugt werden. Die Takterzeugung kann synchron mit der Frequenz des Leistungssignals erfolgen.

Die Frequenz des Taktsignals kann > 1 MHz sein.

Es kann eine Arc-Managementschaltung vorgesehen sein, die mit der Arcerkennung und zumindest einem DAC verbunden ist. Dadurch, dass die Arc-Managementschaltung mit der Arcerkennung verbunden ist, erfährt sie, wenn ein Arc erkannt wurde. Wenn die Arcerkennung direkt den DAC ansteuern kann und somit zu einer Leistungsreduzierung führen kann, kann die Arc-Managementschaltung die weitere Datenverarbeitung übernehmen und insbesondere erfassen, ob ein Arc erloschen ist oder nicht, und in Abhängigkeit davon ebenfalls den DAC ansteuern.

Der DAC kann einen Digitalsignaleingang und einen Referenzsignaleingang aufweisen, und die Arc-Managementschaltung kann in Abhängigkeit von dem durch die Arcerkennung ermittelten Arcerkennungssignal zumindest ein Eingangssignal für einen Eingang des DAC erzeugen. Insbesondere kann die Arc-Managementschaltung das Referenzsignal, welches dem Referenzsignaleingang zugeführt wird, verändern. Selbst bei gleichbleibender Folge von Digitalwerten, die dem DAC zugeführt werden, kann somit das von dem DAC erzeugte Ausgangssignal beeinflusst werden.

Der Leistungswandler kann mehrere Verstärkerpfade aufweisen, denen jeweils ein DAC zugeordnet ist, der dem jeweiligen Verstärkerpfad ein Analogsignal zuführt. Somit kann parallel in mehreren Verstärkerpfaden ein Leistungssignal erzeugt werden. In den Verstärkerpfaden kann dasselbe Leistungssignal erzeugt werden oder es können unterschiedliche Leistungssignale erzeugt werden. Durch die parallele Anordnung von Verstärkerpfaden ergibt sich eine besonders kompakte Bauweise für hohe Ausgangsleistungen. Ein solcher Leistungswandler ist besonders gut abstimmbar.

Die Verstärkerpfade können mit einem Kombinierer zur Kombination der in den Verstärkerpfaden erzeugten Leistungen zu einer Gesamtleistung verbunden sein. Hierbei können relativ einfache Kombinierer verwendet werden, die günstiger in der Herstellung sind, aber hohe Anforderungen hinsichtlich der Phasenlage, Amplituden und Frequenzen der Eingangssignale stellen. Der Leistungswandler kann hierdurch in besonders kompakter Bauweise und kostengünstig aufgebaut werden.

Der Kombinierer kann zur Kombination der in den Verstärkerpfaden erzeugten Leistungen ohne Ausgleichsimpedanzen für Eingangssignale ungleicher Stärke und/oder Phasenlage ausgelegt sein. Ein solcher Kombinierer ist besonders energiesparend und kostengünstig. Außerdem kann ein solcher Kombinierer sehr kompakt und mit wenigen Bauteilen aufgebaut werden.

Die Verstärkerpfade können Transistoren in LDMOS-Technologie aufweisen. LDMOS steht für "laterally diffused metal oxide semiconductor". Dies sind MOSFET's, die bisher vor allem im GHz-Bereich Anwendung fanden. Die Verwendung dieser Transistoren im Bereich unter 200 MHz ist bislang noch nicht bekannt. Beim Einsatz in Verstärkern zur Erzeugung einer Leistung, die einem Plasmaprozess zuführbar ist, hat sich überraschenderweise gezeigt, dass sich diese Transistoren in LDMOS-Technologie sehr viel zuverlässiger verhalten als vergleichbare herkömmliche MOSFET's. Dies kann auf eine sehr viel höhere Strombelastbarkeit zurückzuführen sein. Insbesondere bei Versuchen mit mehreren Verstärkerpfaden und bei Frequenzen von 3,4 MHz, 13 MHz, 27 MHz, 40 MHz und 162 MHz haben diese Transistortypen eine besonders hohe Zuverlässigkeit gezeigt. Ein weiterer Vorteil dieser Transistortypen gegenüber herkömmlichen MOSFET's besteht darin, dass die identischen Transistoren für die genannten Frequenzen (3,4 MHz, 13 MHz, 27 MHz, 40 MHz und 162 MHz) einsetzbar sind. Damit lassen sich nun in einer sehr ähnlichen oder auch gleichen Topologie Verstärker und Leistungsversorgungssysteme aufbauen, die bei Frequenzen über mehrere Dekaden im Bereich von 1MHz bis 200 MHz einsetzbar sind. Dies sind Frequenzen, wie sie in Plasmaprozessen und zur Gaslaseranregung oft benutzt werden. Die Frequenz ist durch einfache Veränderung der Ansteuerung der DACs einstellbar, die Amplitude durch Veränderung der Werte im Digitalspeicher bzw. in Nachschautabellen (Look-Up-Tables). Herkömmliche MOSFET's haben bei diesen Frequenzen betrieben an Plasmaprozessen oftmals Probleme, wenn zu viel in den Plasmaprozess gelieferte Leistung zurückreflektiert wird. Deswegen musste die erzeugte Leistung oft begrenzt werden, um die reflektierte Leistung nicht über eine kritische Grenze ansteigen zu lassen. Damit ließen sich die Plasmaprozesse nicht immer sicher zünden oder im gewünschten Leistungsbereich betreiben. Außerdem wurden aufwändige regelbare Impedanzanpassungsschaltungen und Kombinierer vorgesehen, um diese Nachteile zu beheben. LDMOS-Transistoren sind besonders vorteilhaft einsetzbar, wenn mit reflektierter Leistung in erheblichem Maß zu rechnen ist, wie dies beispielsweise bei der Versorgung von Plasmaprozessen der Fall ist. In Verbindung mit dem oben erwähnten Kombinierer besteht der Vorteil der LDMOS-Transistoren darin, dass sehr viel höhere reflektierte Leistungen von den Transistoren aufgenommen werden können. Dadurch werden die Anforderungen an zusätzliche Zwischenleistungsversorgungssysteme und lastgeschaltete Impedanzanpassungsnetzwerke niedriger und es können bei diesen Impedanzanpassungsnetzwerken Kosten für Bauteile und Regelung eingespart werden.

Die Ansteuerschaltung kann als FPGA ausgebildet sein, das mit einem DAC der Verstärkerpfade verbunden ist, oder in ein solches integriert sein. Eine als FPGA ausgebildete Ansteuerschaltung kann besonders schnell arbeiten. Das FPGA kann durch einen digitalen Signalprozessor (DSP) angesteuert sein. Auch dadurch ergibt sich eine besonders schnelle Signalverarbeitung und entsprechend schnelle Reaktion auf das Erkennen eines Arcs in der Plasmakammer. Das FPGA kann die Arc-Managementschaltung aufweisen.

Der Leistungswandler kann Hochfrequenzleistung mit einer Frequenz > 1 MHz erzeugen, und das von dem DAC dem Verstärkerpfad zugeführte Analogsignal kann ein Signal mit dieser Frequenz sein.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Ein bevorzugtes Ausführungsbeispiel der Erfindung ist in der Zeichnung schematisch dargestellt und wird nachfolgend mit Bezug zu den Figuren der Zeichnung näher erläutert. Es zeigen:
- Fig. 1: in stark schematisierter Darstellung ein Plasmasystem mit einem Leistungsversorgungssystem;
- Fig. 2: in einer Blockdarstellung ein Leistungsversorgungssystem;
- Fig. 3: in einer Blockdarstellung ein DDS Baustein;
- Fig. 4: ein Diagramm, welches den Verlauf eines Referenzsignals darstellt, wie es beispielsweise beim Erkennen eines Arcs erzeugt werden kann.
- Fig. 5: in einer Blockdarstellung ein Leistungsversorgungssystem

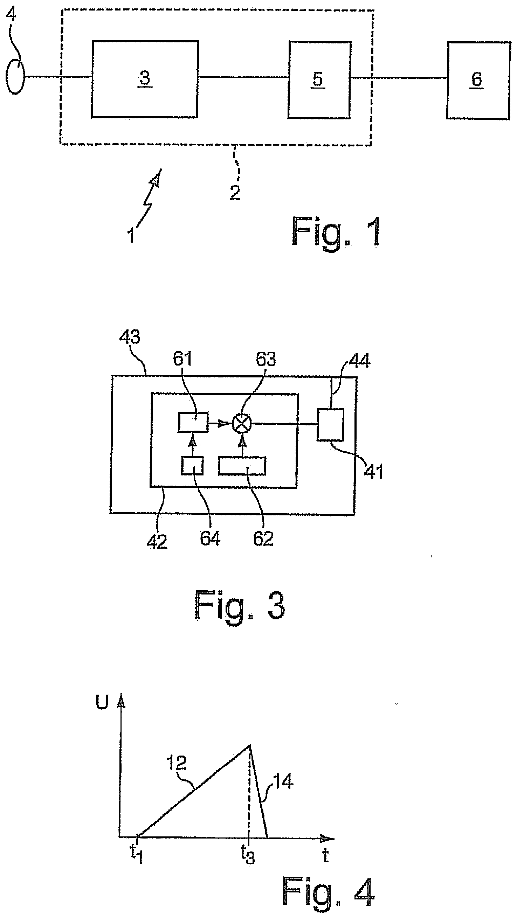

Die Figur 1 zeigt ein Plasmasystem 1, welches ein Leistungsversorgungssystem 2 umfasst. Das Leistungsversorgungssystem 2 weist wiederum einen Leistungswandler 3 auf, der an ein Spannungsversorgungsnetz 4 angeschlossen sein kann. Die am Ausgang des Leistungswandlers 3 erzeugte Leistung wird über ein Impedanzanpassungsnetzwerk 5 an eine Plasmakammer 6 gegeben, wo ein Plasma erzeugt wird, mithilfe dessen eine Plasmabearbeitung in der Plasmakammer 6 durchgeführt werden kann. Insbesondere kann ein Werkstück geätzt werden oder kann eine Materialschicht auf ein Substrat aufgebracht werden.

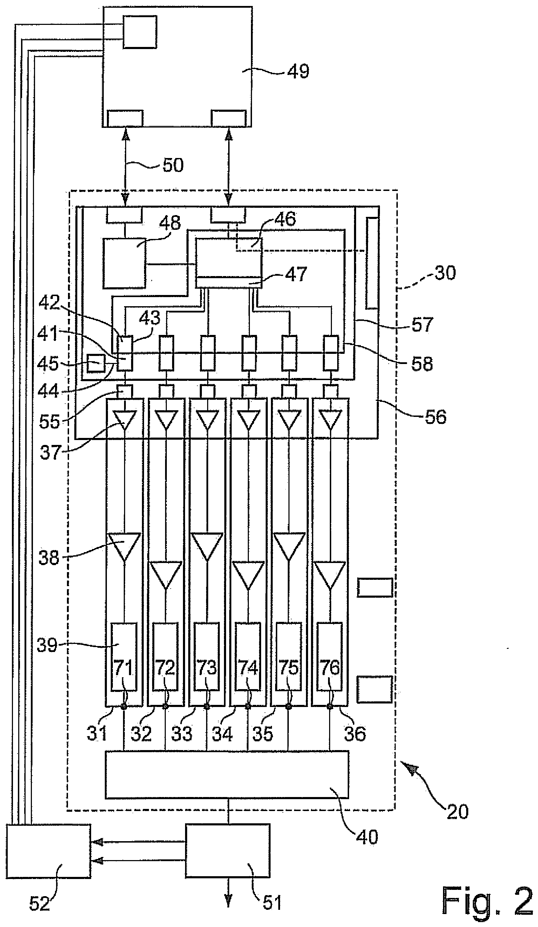

Die Figur 2 zeigt in stark schematisierter Darstellung ein Leistungsversorgungssystem 20. Das Leistungsversorgungssystem 20 weist einen Leistungswandler 30 auf, der eine Ausgangsleistung erzeugt, die einer Last, beispielsweise einem Plasmaprozess oder einer Laseranregung, zugeführt werden kann. In dem Leistungswandler 30 sind mehrere Verstärkerpfade 31 - 36 vorgesehen. Die Verstärkerpfade 31 - 36 sind weitestgehend identisch aufgebaut. Daher wird nachfolgend nur noch der Verstärkerpfad 31 beschrieben. Die Verstärkerpfade 31 - 36 weisen mehrere Verstärker 37, 38 auf, die geeignet sind, ein Analogsignal zu verstärken. Am Ende der Verstärkerpfade 31 - 36 ist jeweils ein Verstärker 39 mit zumindest einem LDMOS-Transistor vorgesehen, dessen Ausgang direkt oder indirekt, z.B. über ein Impedanzanpassungsglied und/oder Filter, auf einen Kombinierer 40 geschaltet ist. Insbesondere sind sämtliche Ausgänge sämtlicher Verstärkerpfade 31 - 36, insbesondere in gleicher Weise, auf den Kombinierer 40 geschaltet. Durch den Kombinierer 40 werden die Einzelleistungen der Verstärkerpfade 31 - 36 zu einer Gesamtleistung gekoppelt.

Dass die Verstärkerpfade 31 - 36 weitestgehend identisch aufgebaut sind, bedeutet nicht zwingend, dass sie die gleiche Verstärkung besitzen. Bauteilstreuung und Toleranzen beim Aufbau der Schaltungen können zu erheblichen Differenzen in der Phase und/oder in der Amplitude der in den Verstärkerpfaden 31 - 36 erzeugten Hochfrequenzleistungssignalen bei identischem Eingangssignal führen.

Den Verstärkerpfaden 31 - 36 ist jeweils ein DAC 41 vorgeschaltet, dem eine Logikschaltungseinheit 42 zugeordnet ist. Insbesondere werden dem DAC 41 aus der Logikschaltungseinheit 42 Folgen von Digitalwerten zugeführt, aus denen der DAC 41 ein analoges Ausgangssignal erzeugt, welches einem Verstärkerpfad 31 -36 - gegebenenfalls nach Filterung durch einen optionalen Filter 55 - zugeführt wird. Der DAC 41 und die Logikschaltungseinheit 42 können in einem sogenannten Direkt-Digital-Synthese-Baustein (DDS-Baustein) 43 integriert sein, auch genannt: Direct-Digital-Synthesizer. Jedem der Verstärkerpfade 31 - 36 ist ein eigener DDS-Baustein 43 und entsprechend ein DAC 41 und eine Logikschaltungseinheit 42 zugeordnet.

Beispielhaft ist der DDS-Baustein 43 in Figur 3 beschrieben.

Die Logikschaltungseinheit 42 weist hier auf:
1. einen Signal-Datenspeicher 61, in dem Signal-Datenwerte zur Erzeugung des Analogsignalform abgelegt sind,
2. einen Amplituden-Datenspeicher 62, in dem Amplituden-Datenwerte zur Beeinflussung der Amplituden der Analogsignale abgelegt sind,
3. einen Multiplikator 63 zur Multiplikation der Signal-Datenwerte mit den Amplituden-Datenwerten und
4. einen Zähler 64, der dafür sorgt, dass in einem vorbestimmten Takt Signal-Datenwerte aus dem Signal-Datenspeicher 61 ausgelesen und dem Multiplikator zugeführt werden.

Sowohl der Signal-Datenspeicher 61 als auch der Amplituden-Datenspeicher 62 können als sogenannte Nachschautabellen (Look-Up-Tables, LUT) ausgebildet sein.

Der DAC 41 weist weiterhin einen Referenzsignaleingang 44 auf, dem eine Ansteuerschaltung 45 vorgeschaltet sein kann, um ein Referenzsignal zu erzeugen. Die Ansteuerschaltung 45 kann in der noch zu beschreibenden digitalen Logikschaltung (Programmable Logic Device, PLD) 46 realisiert werden. Die digitale Logikschaltung kann als eine Feld programmierbare (Logik-)Gatter-Anordnung (Field Programmable Gate Array, FPGA) ausgebildet sein. Ebenso kann die Ansteuerschaltung 45 als FPGA ausgebildet sein oder Bestandteil eines FPGA sein.

Durch das am Referenzsignaleingang 44 eingegebene Referenzsignal kann das Ausgangssignal, also das generierte Analogsignal des DAC 41, beeinflusst werden. Dem DDS-Baustein 43 ist die digitale Logikschaltung 46 vorgeschaltet, welche insbesondere ebenfalls einen als Look-Up-Table (LUT) ausgebildeten Speicher 47 aufweist. In dem Speicher 47 können Amplituden-Datenwerte abgelegt sein, die vom Speicher 47 in den Amplituden-Datenspeicher 62 geschrieben werden können. Zusätzlich können auch Daten zur Phasenkorrektur abgelegt sein. Die Werte, die im Speicher 47 abgelegt sind, dienen der Kompensierung von Unterschieden in den Verstärkerpfaden 31-36 oder in nachgeschalteten Kombinierern 40. Sie können der Logikschaltungseinheit 42, insbesondere dem Amplituden-Datenspeicher 62, übergeben werden. Die digitale Logikschaltung 46 wird durch einen digitalen Prozessor, insbesondere Digitalen Signalprozessor (DSP) 48 angesteuert, der mit einer Systemsteuerung 49 über einen Datenbus 50 in Verbindung steht.

Der digitale Prozessor, insbesondere Digitale Signalprozessor (DSP) 48, der Speicher 47 und die Logikschaltungseinheiten 42 können in einem Logikbauelement 58 realisiert werden. Das Logikbauelement 58 kann als digitale Logikschaltung PLD, insbesondere FPGA, ausgebildet sein. Wenn auch noch die DAC 41 integriert werden, ergibt sich ein kompakter Logikbaustein 57. Der digitale Prozessor, insbesondere DSP, 48, der Speicher 47, die DDS-Bausteine 43 und auch die DACs 41 sowie die Filter 55 und die ersten Verstärker 37 können auf einer Leiterkarte 56 realisiert werden. Die identische Leiterkarte 56 kann für eine Vielzahl unterschiedlicher Leistungsversorgungssysteme mit unterschiedlichen Leistungen, unterschiedlichen Frequenzen und unterschiedlichen Versorgungslasten (Laser, Plasma etc.) eingesetzt werden.

Die Ausgangsleistung des Kombinierers 40 wird über einen Richtkoppler 51 an eine Last, z.B. einen Plasmaprozess, gegeben. Durch den Richtkoppler 51 kann die ausgegebene Leistung und eine von der Last reflektierte Leistung erfasst werden. Die Messsignalaufbereitung erfolgt mit Messmitteln 52, die mit dem Richtkoppler 51 in Verbindung stehen. Die Messmittel 52 sind wiederum mit der Systemsteuerung 49 verbunden. Somit kann über die Systemsteuerung 49 anhand der erfassten Ausgangsleistung und der erfassten reflektierten Leistung bestimmt werden, welche Ausgangsleistung vom Kombinierer 40 erzeugt werden soll. Entsprechend dieser Vorgabe kann die Systemsteuerung 49 den DSP 48 und dieser wiederum das FPGA 46 ansteuern.

In den Messmitteln kann eine Arcerkennung realisiert sein. Um eine schnelle Reaktion auf einen Arc zu erreichen, kann die Arcerkennung, d.h. die Messmittel, unmittelbar mit dem DAC 41, insbesondere dessen Referenzsignaleingang 44, oder der Ansteuerschaltung 45, in Verbindung stehen.

In den Speichern 47 sind Digitalwerte abgespeichert, die sowohl eine Amplitudeninformation als auch eine Phasen- und ggf. auch Frequenzinformation enthalten, so dass am Ausgang des DAC 41 ein Analogsignal mit einer vorgegebenen Amplitude, Frequenz- und Phasenlage erzeugt werden kann. Dadurch ist es möglich, die Ausgangssignale der einzelnen Verstärkerpfade 31 - 36 aufeinander abzustimmen, so dass diese im Kombinierer 40 für eine verbesserte Ausgangsleistung gekoppelt werden können. Insbesondere können auf diese Art und Weise sehr einfache Kombinierer 40 ohne Verlust erzeugende Ausgleichsimpedanzen eingesetzt werden und eine Verlustleistung gering gehalten werden.

Durch die erfindungsgemäße Art und Weise ein analoges Signal zu erzeugen, kann sehr schnell die Leistung im Ausgang des Kombinierers 40 beeinflusst und verändert werden.

In dem Diagramm der Figur 4 ist eine Spannung, die einem Eingangssignal am Referenzsignaleingang eines DAC entspricht, gegenüber der Zeit aufgetragen. Bei der Position t1 wird ein Überschlag erkannt. In der Folge wird die Spannung des Referenzsignals erhöht, was durch die Ziffer 12 angedeutet wird. Im gezeigten Fall wird die Spannung des Referenzsignals rampenförmig erhöht. Dies führt dazu, dass das Ausgangssignal des DAC reduziert wird. Anstatt das Referenzsignal rampenförmig zu erhöhen, könnte es auch sprungartig auf einen Maximalwert erhöht werden, was dazu führen würde, dass sprungartig die Arclöschleistung eingestellt wird. Bei der Position t3 wird das Erlöschen des Arcs erkannt. In der Folge wird die Spannung des Referenzsignals reduziert, was durch die Ziffer 14 gezeigt ist. Somit wird die vorher eingestellte Ausgangsleistung des DAC wieder hergestellt.

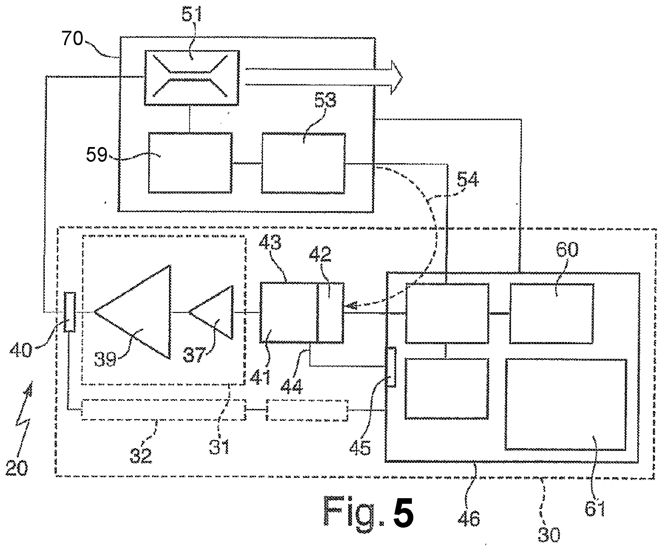

Das in Fig. 5 in einer Blockdarstellung dargestellte Leistungsversorgungssystem 20 ist eine leicht veränderte Darstellung des Leistungsversorgungssystems 20 aus Fig. 2. Die gleichen Komponenten sind mit denselben Referenzeichen versehen. Das Leistungsversorgungssystem 20 weist auch hier einen Leistungswandler 30 auf, der eine Ausgangsleistung erzeugt, die einer Last, beispielsweise einem Plasmaprozess oder einer Laseranregung, zugeführt werden kann. In dem Leistungswandler 30 sind mehrere Verstärkerpfade 31, 32 vorgesehen, wobei hier nur zwei Verstärkerpfade dargestellt sind und der Verstärkerpfad 32 weitestgehend identisch aufgebaut ist wie der Verstärkerpfad 31.

Die Ausgangsleistung des Kombinierers 40 wird über eine Messeinrichtung 70, die einen Richtkoppler 51 aufweist, an eine Last, z.B. einen Plasmaprozess, gegeben. Durch den Richtkoppler 51 kann die ausgegebene Leistung und eine von der Last reflektierte Leistung erfasst werden. Alternativ zum Richtkoppler kann alternativ oder zusätzlich auch andere Auskoppeleinrichtungen verwendet werden, beispielsweise eine Übertragereinrichtung zur Messung von Strom und/oder ein Spannungsteiler zur Messung der Spannung.

Die Messeinrichtung 70, die als Arcerkennung aufgefasst werden kann, weist weiterhin einen ADC 59 auf. Dabei können der Richtkoppler 51 und der ADC 59 auf derselben Leiterkarte angeordnet sein. Der Richtkoppler 51 kann in planarer Bauweise ausgeführt sein. Die Messeinrichtung 70 weist weiterhin eine Logikschaltung 53 auf zur Generierung eines Arcerkennungssignals, welches direkt dem DDS 43 zugeführt wird. Die direkte Zuführung ist durch den Pfeil 54 angedeutet. Insbesondere wird dadurch angedeutet, dass die Leitung für das Arcerkennungssignal durch die digitale Logikschaltung 46 hindurch geschleift werden kann. Die Logikschaltung 53, der Richtkoppler 51 und der ADC 59 können auf einer Leiterkarte realisiert sein. Die ADC 59 und die Logikschaltung 53 können in einem Baustein realisiert sein.

Weiterhin ist eine Arc-Managementschaltung 60 vorgesehen, die im Ausführungsbeispiel in der digitalen Logikschaltung 46, die als FPGA ausgebildet sein kann, angeordnet ist. Die Arc-Managementschaltung ist, da sie in der Logikschaltung 46 angeordnet ist, ebenfalls mit dem DDS 43 bzw. dem DAC 41 verbunden. Dabei kann die Arc-Managementschaltung 60 wie hier gezeigt mit der Logikschaltungseinheit 42 verbunden sein. Alternativ kann der DAC 41 neben dem Referenzsignaleingang einen Digitalsignaleingang aufweisen, der mit der digitalen Logikschaltung 46, insbesondere der Arc-Managementschaltung 60 in Verbindung steht.

Die digitale Logikschaltung 46 kann noch weitere Logikoperatoren aufweisen, was mit der Bezugsziffer 61 angedeutet ist. Die mit der Bezugsziffer 54 angedeutete Leitung kann als spezifische Leitung aufgefasst werden, über die ein Signal besonders schnell an den DAC 41 gegeben werden kann.

Die Aufbereitung des Arcerkennungssignals erfolgt direkt in der Messeinrichtung 70, ohne dass weitere Logikbausteine der digitalen Logikschaltung 46 an der Generierung des Arcerkennungssignals beteiligt wären. Es genügt somit ein einziges Signal, um das System über die Existenz eines Arcs zu informieren. Durch die direkte Anbindung des Arcerkennungssignals an den DAC 41 kann der Arc praktisch ohne Verzögerung wahrgenommen werden. Diese "Ultra-fast Arc-Handling-Routine" kann durch weitere Logik, beispielsweise die Arc-Managementschaltung 60, ergänzt werden, die übergeordnet weitere Entscheidungen trifft, aber deutlich langsamer reagiert.

## Patentansprüche

1. Arclöschverfahren zur Löschung von Arcs in einer Plasmakammer (6) eines Plasmasystems (1), umfassend die Verfahrensschritte:
a. Erzeugung einer Leistung während eines Plasmabetriebs zur Erzeugung eines Plasmas in der Plasmakammer (6) und zur Durchführung eines Plasmabearbeitungsprozesses unter Verwendung des erzeugten Plasmas, indem mit mindestens einem Digital-Analog-Wandler (41) ein Analogsignal generiert wird, das einem Verstärkerpfad (31, 32) zugeführt und dort verstärkt wird;
b. Überwachung des Plasmasystems (1) hinsichtlich des Auftretens eines Arcs durch eine Arcerkennung;
c. bei Erkennen eines Arcs im Schritt b.:
Ansteuern des mindestens einen Digital-Analog-Wandlers (DAC) (41) durch die Arcerkennung, derart, dass ein analoges Ausgangssignal des mindestens einen DACs (41) verändert wird, **dadurch gekennzeichnet, dass** die Erzeugung der Leistung erfolgt, indem eine Hochfrequenzleistung erzeugt wird und der oder die Digital-Analog-Wandler (DAC) (41) so angesteuert werden (wird), dass diese(r) ein Signal mit dieser Frequenz erzeugen (erzeugt).

2. Arclöschverfahren nach Anspruch 1, wobei ein oder mehrere Digital-Analog-Wandler (41) bei Erkennen eines Arcs durch die Arcerkennung angesteuert werden.

3. Arclöschverfahren nach einem der vorhergehenden Ansprüche, wobei die Arcerkennung eine Arcmanagementschaltung (60) ansteuert, die wiederum direkt oder indirekt den oder die DAC (41) ansteuert.

4. Arclöschverfahren nach einem der vorhergehenden Ansprüche, wobei die Überwachung des Plasmasystems (1) hinsichtlich des Auftretens eines Arcs erfolgt, indem ein mit der in das Plasma gelieferten Leistung Pi und/oder ein mit der von dem Plasma reflektierten Leistung Pr und/oder mit einem in das Plasma fließenden Strom und/oder einer an das Plasma angelegten Spannung in Beziehung stehendes Signal erfasst wird und daraus ein Arcerkennungssignal generiert wird.

5. Arclöschverfahren nach Anspruch 4, wobei das erfasste Signal von einem Analog Digital Wandler (ADC) (59) in digitalisierte Werte umgesetzt wird, diese digitalisierten Werte einer Logikschaltung (53), insbesondere einem programmierbaren Logikbaustein (PLD) zugeführt werden, wobei der PLD diese digitalisierten Werte auswertet und das Arcerkennungssignal erzeugt.

6. Arclöschverfahren nach einem der vorhergehenden Ansprüche, wobei die Erzeugung der Leistung erfolgt, indem eine Hochfrequenzleistung mit einer Frequenz größer 1 MHz erzeugt wird.

7. Arclöschverfahren nach einem der vorhergehenden Ansprüche 5 bis 6, wobei das erfasste Signal vom ADC (59) mit einer Frequenz größer 1 MHz abgetastet wird und der PLD mit einem Taktsignal einer Frequenz größer 1 MHz getaktet wird.

8. Arclöschverfahren nach einem der vorhergehenden Ansprüche 5 bis 7, wobei dem ADC (59) und dem PLD dasselbe Taktsignal zugeführt wird.

9. Arclöschverfahren nach einem der vorhergehenden Ansprüche, wobei in Schritt c. eine Arclöschleistung erzeugt wird, die geringer ist als die Plasmabetriebsleistung zur Versorgung der Plasmakammer (6) mit der Arclöschleistung während eines Arclöschbetriebs,
wobei die Plasmabetriebsleistung und die Arclöschleistung zumindest teilweise erzeugt werden, indem ein Digital-Analog-Wandler (DAC) (41) in Abhängigkeit von der Überwachung des Plasmasystem hinsichtlich des Auftretens eines Arcs angesteuert wird und das analoge Ausgangssignal des DAC (41) in einem nachfolgenden Verstärkerpfad (31-36) zu zumindest einem Teil der Plasmaleistung oder der Arclöschleistung verstärkt wird.

10. Arclöschverfahren nach einem der vorhergehenden Ansprüche, wobei ein oder mehrere weitere Digital-Analog-Wandler (41) in Abhängigkeit von der Überwachung des Plasmasystem hinsichtlich des Auftretens eines Arcs angesteuert werden und das jeweilige analoge Ausgangssignal der Digital-Analog-Wandler (41) in einem nachfolgenden Verstärkerpfad (31-36) zu einem Teil der Plasmaleistung oder der Arclöschleistung verstärkt wird.

11. Arclöschverfahren nach einem der vorhergehenden Ansprüche, wobei die analogen Ausgangssignale von zumindest zwei DAC (41) in den jeweils nachfolgenden Verstärkerpfaden (31-36) unterschiedlich verstärkt werden oder unterschiedliche Durchlaufzeiten durch die Verstärkerpfade (31-36) erfahren.

12. Arclöschverfahren nach einem der vorhergehenden Ansprüche, wobei dem zumindest einen Verstärkerpfad (31-36) ein von einem DAC (41) aus einem Digitalsignal erzeugtes Analogsignal zugeführt und in dem Verstärkerpfad zu einem Hochfrequenzleistungssignal verstärkt wird, wobei das Digitalsignal erzeugt wird, indem ein in einem Signal-Datenspeicher (61) abgelegter Signal-Datenwert mit einem in einem Amplituden-Datenspeicher (62) abgelegten Amplituden-Datenwert multipliziert wird.

13. Arclöschverfahren nach einem der vorhergehenden Ansprüche, wobei bei Erkennen eines Arcs stufenweise oder rampenförmig von der Plasmabetriebsleistung auf die Arclöschleistung übergegangen wird.

14. Leistungsversorgungssystem (20) mit einem ein Hochfrequenzsignal erzeugenden Leistungswandler (30), der zur Versorgung eines Plasmaprozesses mit Hochfrequenz-Leistung mit einer Plasmakammer (6) verbindbar ist, wobei der Leistungswandler (30) einen ersten Verstärkerpfad (31-36) aufweist **dadurch gekennzeichnet, dass** das Leistungsversorgungssystem (20) weiter einen Digital-Analog-Wandler (DAC) (41) aufweist, der dem Verstärkerpfad (31-36) vorgeschaltet ist, und dass dem ersten Verstärkerpfad (31-36) ein von dem DAC (41) erzeugtes Analogsignal zugeführt ist, wobei der DAC (41) zumindest mittelbar insbesondere direkt mit einer Arcerkennung verbunden ist.

15. Leistungsversorgungsystem nach Anspruch 14, wobei eine Messeinrichtung (70) vorgesehen ist, in die die Arcerkennung integriert ist, wobei die Messeinrichtung (70) einen ADC (59) aufweist und wobei die Messeinrichtung (70) eine Logikschaltung (53) zur Generierung des Arcerkennungssignals aufweist.

## Claims

1. Arc extinguishing method for extinguishing arcs in a plasma chamber (6) of a plasma system (1), comprising the method steps of:
a. generation of power during a plasma operation for producing plasma in said plasma chamber (6) and for carrying out a plasma-processing process using the produced plasma, in which at least one digital-to-analogue converter (41) generates an analogue signal that is supplied to an amplifier path (31, 32) and amplified there;
b. monitoring the plasma system (1) with regard to the presence of an arc by means of arc detection;
c. if an arc is detected in step b.:
controlling the at least one digital-to-analogue converter (DAC) (41) by the arc detection in such a way that an analogue output signal of the at least one DAC (41) is modified, **characterised in that** the generation of power is realised **in that** high-frequency power is generated and the digital-to-analogue converter(s) (DAC) (41) is (are) controlled in such a way that the same generate(s) a signal with this frequency

2. Arc extinguishing method according to claim 1, whereby one or more digital-to-analogue converters (41) are controlled by the arc detection upon detection of an arc.

3. Arc extinguishing method according to one of the preceding claims, whereby the arc detection controls an arc management circuit (60), which in turn controls the DAC(s) (41) directly or indirectly.

4. Arc extinguishing method according to one of the preceding claims, whereby monitoring of the plasma system (1) for the occurrence of an arc is carried out in that a signal related to a power Pi supplied to the plasma and/or a power Pr reflected by the plasma and/or a current flowing into the plasma and/or a voltage applied to the plasma is recorded, and an arc detection signal generated from the same.

5. Arc extinguishing method according to claim 4, whereby the recorded signal is converted into digitalised values by an analogue-to-digital converter (ADC) (59), and these digitalised values supplied to a logic circuit (53), in particular a programmable logic component (PLD), whereby the PLD evaluates these digitalised values and generates the arc detection signal.

6. Arc extinguishing method according to one of the preceding claims, whereby the generation of power is realised in that high-frequency power with a frequency of more than 1 MHz is generated.

7. Arc extinguishing method according to one of the preceding claims 5 to 6, whereby the recorded signal is sampled by the ADC (59) with a frequency of more than 1 MHz, and the PLD clocked with a clock signal of a frequency of more than 1 MHz.

8. Arc extinguishing method according to one of the preceding claims 5 to 7, whereby the ADC (59) and the PLD are supplied with the same clock signal.

9. Arc extinguishing method according to one of the preceding claims, whereby in step c. an arc extinguishing power is generated that is smaller than the plasma operating power for supplying the plasma chamber (6) with the arc extinguishing power during the arc extinguishing operation,
whereby the plasma operating power and the arc extinguishing power are generated at least in part in that a digital-to-analogue converter (DAC) (41) is controlled in dependence on monitoring the plasma system with regard to the occurrence of an arc, and the analogue output signal of the DAC (41) on one of the subsequent amplifier paths (31-36) is amplified to at least a part of the plasma power or the arc extinguishing power.

10. Arc extinguishing method according to one of the preceding claims, whereby one or more further digital-to-analogue converters (41) are controlled in dependence on monitoring the plasma system with regard to the occurrence of an arc, and the relevant analogue output signal of the digital-to-analogue converters (41) is amplified on one of the subsequent amplifier paths (31-36) to a part of the plasma power or the arc extinguishing power.

11. Arc extinguishing method according to one of the preceding claims, whereby the analogue output signals of at least two DACs (41) are amplified differently on the relevant amplifier paths (31-36), or are subjected to different cycle times through the amplifier paths (31-36).

12. Arc extinguishing method according to one of the preceding claims, whereby the at least one amplifier path (31-36) is supplied with an analogue signal generated from a digital signal by a DAC (41) and amplified on the amplifier path into a high-frequency power signal, whereby the digital signal is generated in that a signal data value stored in a digital data memory (61) is multiplied by an amplitude data value stored in an amplitude data memory (62).

13. Arc extinguishing method according to one of the preceding claims, whereby a stepped or ramped transfer from plasma operating power to arc extinguishing power takes place upon detection of an arc.

14. Power supply system (20) with a power converter (30) generating a high-frequency signal, connectable with a plasma chamber (6) for supplying a plasma process with high-frequency power, whereby the power converter (30) comprises a first amplifier path (31-36), **characterised in that** the power supply system further comprises a digital-to-analogue converter (DAC) (41) which is connected upstream of the amplifier path (31-36) and that the first amplifier path (31-36) is supplied with an analogue signal generated by the DAC (41), whereby the DAC (41) is connected at least indirectly, but in particular directly with an arc detection.

15. Power supply system according to claim 14, whereby a measuring means (70), into which the arc detection is integrated, is provided, whereby the measuring means (70) comprises an ADC (59), and whereby the measuring means (70) comprises a logic circuit (53) for generating the arc detection signal.

## Revendications

1. Procédé d'extinction d'arcs permettant d'éteindre des arcs dans une chambre à plasma (6) d'un système de plasma (1), comprenant les étapes opératoires suivantes :
a. génération d'une puissance pendant un mode plasma pour générer un plasma dans la chambre à plasma (6) et pour réaliser un processus de traitement au plasma en utilisant le plasma généré en générant au moyen d'au moins un convertisseur numérique-analogique (41) un signal analogique qui est acheminé à une piste d'amplification (31, 32) et est amplifié la-bàs;
b. surveillance du système de plasma (1) en ce qui concerne la survenance d'un arc par un système de détection d'arcs ;
c. en cas de détection d'un arc dans l'étape b :
commande de l'au moins un convertisseur numérique-analogique (DAC) (41) par le système de détection d'arcs de manière à ce qu'un signal de sortie de l'au moins un DAC (41) soit modifié, **caractérisé en ce que** la génération de la puissance a lieu par le fait qu'une puissance à haute fréquence est générée et que le ou les convertisseurs numérique-analogique (DAC) (41) est ou sont commandés de manière à ce que celui-ci ou ceux-ci génère(nt) un signal à cette fréquence.

2. Procédé d'extinction d'arcs selon la revendication 1, dans lequel un ou plusieurs convertisseurs analogique-numérique (41) sont commandés en cas de détection d'un arc par le système de détection d'arcs.

3. Procédé d'extinction d'arcs selon une des revendications précédentes, dans lequel le système de détection d'arcs commande un circuit de contrôle d'arcs (60) qui commande à son tour directement ou indirectement le ou les DAC (41).

4. Procédé d'extinction d'arcs selon une des revendications précédentes, dans lequel la surveillance du système de plasma (1) en ce qui concerne la survenance d'un arc a lieu par le fait qu'un signal en relation avec la puissance Pi délivrée dans le plasma et/ou une puissance Pr reflétée par le plasma et/ou un courant s'écoulant dans le plasma et/ou une tension appliquée au plasma est détecté et un signal de détection d'arcs est généré à partir de là.

5. Procédé d'extinction d'arcs selon la revendication 4, dans lequel le signal détecté est transformé par un convertisseur analogique-numérique (ADC) (59) en valeurs numérisées, ces valeurs numérisées sont acheminées à un circuit logique (53), en particulier un module logique programmable (PLD), le PLD exploitant ces valeurs numérisées et générant le signal de détection d'arcs.

6. Procédé d'extinction d'arcs selon une des revendications précédentes, dans lequel la génération de la puissance a lieu en générant une puissance à haute fréquence ayant une fréquence supérieure à 1 MHz.

7. Procédé d'extinction d'arcs selon une des revendications précédentes 5 à 6, dans lequel le signal détecté est balayé à une fréquence supérieure à 1 MHz par l'ADC (59) et le PLD est balayé avec un signal d'horloge d'une fréquence supérieure à 1 MHz.

8. Procédé d'extinction d'arcs selon une des revendications précédentes 5 à 7, dans lequel le même signal d'horloge est acheminé à l'ADC (59) et au PLD.

9. Procédé d'extinction d'arcs selon une des revendications précédentes, dans lequel, dans l'étape c., il est généré une puissance d'extinction d'arcs qui est plus faible que la puissance du mode plasma pour l'alimentation de la chambre à plasma (6) avec la puissance d'extinction d'arcs pendant un mode d'extinction d'arcs,
la puissance du mode plasma et la puissance d'extinction d'arcs étant générées du moins partiellement en commandant un convertisseur numérique-analogique (DAC) (41) en fonction de la surveillance du système de plasma en ce qui concerne la survenance d'un arc et le signal analogique de sortie du DAC (41) est amplifié dans une piste d'amplification suivante (31-36) pour au moins une partie de la puissance de plasma ou de la puissance d'extinction d'arcs.

10. Procédé d'extinction d'arcs selon une des revendications précédentes, dans lequel un ou plusieurs autres convertisseurs numériques-analogique (41) sont commandés en fonction de la surveillance du système de plasma en ce qui concerne la survenance d'un arc et que le signal analogique de sortie respectif du convertisseur numérique-analogique (41) est amplifié dans une piste d'amplification suivante (31-36) pour une partie de la puissance de plasma ou de la puissance d'extinction d'arcs.

11. Procédé d'extinction d'arcs selon une des revendications précédentes, dans lequel les signaux analogiques de sortie d'au moins deux DAC (41) sont amplifiés différemment dans les pistes d'amplification respectivement suivantes (31-36) ou connaissent différentes durées de passage dans les pistes d'amplification (31-36).

12. Procédé d'extinction d'arcs selon une des revendications précédentes, dans lequel un signal analogique généré par un DAC (41) est acheminé à l'au moins une piste d'amplification (31-36) et amplifié dans la piste d'amplification pour obtenir un signal de puissance à haute fréquence, le signal numérique étant généré par le fait qu'une valeur de données de signal enregistrée dans une mémoire de données de signaux (61) est multipliée par une valeur de données d'amplitude enregistrée dans une mémoire de données d'amplitude (62).

13. Procédé d'extinction d'arcs selon une des revendications précédentes, dans lequel, en cas de détection d'un arc, on passe graduellement ou en suivant une rampe de la puissance du mode plasma à la puissance d'extinction d'arcs.

14. Système d'alimentation en puissance (20) comportant un convertisseur de puissance (30) générant un signal à haute fréquence qui, pour alimenter un processus au plasma en puissance à haute fréquence, peut être raccordé à une chambre à plasma (6), le convertisseur de puissance (30) présentant une première piste d'amplification (31-36), **caractérisé en ce que** le système d'alimentation en puissance comporte en outre un convertisseur numérique-analogique (DAC) (41) qui est branché en amont de la piste d'amplification (31-36) et qu'un signal analogique généré par le DAC (41) est acheminé à la première piste d'amplification (31-36), le DAC (41) étant raccordé du moins indirectement, en particulier directement, à un système de détection d'arcs.

15. Système d'alimentation en puissance selon la revendication 14, dans lequel il est prévu un dispositif de mesure (70) dans lequel le système de détection d'arcs est intégré, le dispositif de mesure (70) présentant un ADC (59) et le dispositif de mesure (70) présentant un circuit logique (53) pour la génération du signal de détection d'arcs.
